# EUROPÄISCHE PATENTANMELDUNG

(11) **EP 0 841 844 A2**
(43) Veröffentlichungstag der Anmeldung: **13.05.1998**
(21) Anmeldenummer: 97119242.2
(22) Anmeldetag: 04.11.1997
(51) Int. Cl.: H05K 13/00

(54) **Verfahren und Vorrichtung zur Erzeugung eines definierten Stroms horizontal geführter Leiterplatten**

(30) Priorität: 06.11.1996 DE 19645760
(71) Anmelder: Gebr. Schmid Maschinenfabrik GmbH + Co., 72250 Freudenstadt (DE)
(72) Erfinder: Schmid, Dieter C., D-72250 Freudenstadt (DE)
(74) Vertreter: Bunke, Holger, Dr.rer.nat. Dipl.-Chem.

(57) **Zusammenfassung**

Die Erfindung betrifft ein Verfahren und eine Vorrichtung zur Erzeugung eines definierten Stroms von in einer Transportebene horizontal geführten Leiterplatten, wobei die der Vorrichtung mit einer Geschwindigkeit v₁ zugeführten Leiterplatten angehalten, mittels einer horizontal verfahrbaren Hebeeinrichtung angehoben, oberhalb der Transportebene in Transportrichtung beschleunigt und taktweise wieder auf die Transportebene abgesenkt werden, von wo sie mit einer konstanten Geschwindigkeit v₂ einer stromabwärts gelegenen Bearbeitungsstation zugeführt werden. Um zu erreichen, daß die Leiterplatten in einem vorzugsweise sehr geringen konstanten Abstand voneinander mit der gewünschten Geschwindigkeit v₂ abströmen, werden die Bewegungsabläufe der Hebeeinrichtung und die Vorschubgeschwindigkeiten in Abhängigkeit von den Postionen der Leiterplattenvorderkante und der Hinterkante der jeweils vorauseilenden Leiterplatte über eine zentrale Prozeßsteuerungseinheit gesteuert. Die Vorrichtung ist besonders vorteilhaft als Aufschließ- und Zentrierstation in einer Leiterplatten-Herstellungslinie verwendbar.

## Beschreibung

Die Erfindung betrifft ein Verfahren und eine Vorrichtung zur Erzeugung eines definierten Stroms von in einer Transportebene horizontal geführten Leiterplatten.

Bei der Herstellung von Leiterplatten im horizontalen Durchlaufverfahren durchlaufen die Platten eine Vielzahl von Behandlungs- und Bearbeitungsstationen oder -linien, in denen sie gereinigt, entfettet, entgratet werden, in denen Durchgangs- oder Sacklöcher gebohrt werden, Bohrrückstände chemisch entfernt werden (Desmearing) und in denen Leiterbahnen in aufwendigen vielstufigen Prozessen durch stromlose Metallabscheidung und durch galvanische Metallabscheidung gebildet werden. Die einzelnen Bearbeitungsstationen oder -linien bestehen in der Regel aus trog- oder wannenförmigen Behältern, die im wesentlichen allseits geschlossen, aber mindestens von oben zugänglich sind, worin eine Vielzahl achsparalleler Transportwalzen oder -rollen oder eine Anzahl parallel angeordneter Förderbänder eine horizontale Transportebene definieren, in der die Leiterplatten unter Bildung eines kontinuierlichen Stromes mit einer veränderlich einstellbaren Vorschubgeschwindigkeit vorwärts bewegt werden. Die in Transportrichtung einander gegenüberliegenden Gehäusewände der einzelnen Stationen weisen schlitzartige Öffnungen auf, durch die die Leiterplatten hindurchlaufen und auf diese Weise von einer Behandlungsstation zur nächsten gelangen können.

Bei der Station bzw. Linie, in der die galvanische Metallabscheidung zur Bildung der Leiterbahnen stattfindet, muß besonders sorgfältig darauf geachtet werden, daß der eintretende Leiterplattenstrom ein definierter Strom ist, bei dem die einzelnen Platten des Stromes möglichst kantengenau ausgerichtet und zentriert sind und die Abstände der einzelnen Platten voneinander absolut konstant sind und dem von der Anlage und ihren Betriebsbedingungen abhängigen optimalen Wert entsprechen.

Um diesen Anforderungen soweit wie möglich zu genügen, hat man bisher unmittelbar vor dem Elektroplater eine Vorrichtung angeordnet, die die Leiterplatten innerhalb eines horizontal geführten Stromes auf gleiche Abstände bringen und nach einer Seite ausrichten sollte. Dabei wurden Saugheber als Hebeeinrichtung verwendet, mit denen die Leiterplatten von der Transportebene abgehoben, in Transportrichtung beschleunigt und in definiertem Abstand von der Hinterkante der jeweils vorauseilenden Leiterplatte wieder auf die Transportebene abgesenkt wurden. Vor oder nach dem Saughebereinsatz wurden die Leiterplatten ausgerichtet bzw. zentriert.

Es hat sich jedoch gezeigt, daß die Saugheber nicht mit der erforderlichen Präzision arbeiten, weil die Aufrechterhaltung des erforderlichen Unterdrucks wegen der vielen Bohrungen in den Leiterplatten schwierig ist, vor allem dann, wenn unterschiedliche Leiterplattenformate und Leiterplatten mit unterschiedlichen Bohrungsmustern bearbeitet werden müssen. Wenn aber der erforderliche Unterdruck nicht erreicht wird, besteht die Gefahr, daß die vom Saugheber angehobenen Platten während des Transports ihre Lage verändern, so daß ein gestörter Leiterplattenstrom entsteht, sei es infolge unterschiedlicher Abstände zwischen den einzelnen Platten oder sei es infolge mangelnder Ausrichtung bzw. Zentrierung der Platten. Es kommt hinzu, daß die Saugheber eine Vakuumquelle und verhältnismäßig viel Platz benötigen, was wiederum mit einem erheblichen apparativen Aufwand verbunden ist.

Der Erfindung liegt deshalb die Aufgabe zugrunde, ein Verfahren und eine Vorrichtung der vorstehend beschriebenen Gattung zu schaffen, mit denen es gelingt, mit größerer Präzision und Zuverlässigkeit als bisher einen hinsichtlich der Plattenabstände und hinsichtlich der Ausrichtung bzw. Zentrierung der Leiterplatten definierten Leiterplattenstrom zu schaffen und gleichzeitig den apparativen Aufwand und Platzbedarf für eine solche Vorrichtung und für die Durchführung eines solchen Verfahrens zu verringern.

Diese Aufgabe wird erfindungsgemäß durch das Verfahren gemäß Patentanspruch 1 und durch die Vorrichtung gemäß Patentanspruch 12 gelöst. Vorteilhafte Weiterbildungen des erfindungsgemaßen Verfahrens sind durch die Merkmale der Patentansprüche 2 bis 11 und vorteilhafte Ausführungsformen der erfindungsgemäßen Vorrichtung sind durch die Merkmale der Patentansprüche 13 bis 22 gekennzeichnet.

Gegenstand der Erfindung ist somit ein Verfahren zur Erzeugung eines definierten Stroms von in einer Transportebene horizontal geführten Leiterplatten, bei dem die von einer stromaufwärts gelegenen Bearbeitungsstation kommenden, mit einer veränderlich einstellbaren, konstanten Vorschubgeschwindigkeit v₁ zugeführten Leiterplatten einzeln nacheinander an einer vorbestimmten Position P₁ angehalten, mittels einer horizontal verfahrbaren Hebeeinrichtung angehoben, oberhalb der Transportebene in Transportrichtung T beschleunigt und taktweise an einer vorbestimmten Position P₂ wieder auf die Transportebene abgesenkt werden, von wo sie mit einer veränderlich einstellbaren, konstanten Vorschubgeschwindigkeit v₂ einer stromabwärts gelegenen Bearbeitungsstation zugeführt werden, wobei die Bewegungsabläufe der Hebeeinrichtung und die Vorschubgeschwindigkeiten v₁ und v₂ in Abhängigkeit von der Ankunft der Leiterplattenvorderkante an der Position P₁ und der Ankunft der Hinterkante der jeweils vorauseilenden Leiterplatte an der Position P₂ so gesteuert werden, daß die Leiterplatten in einem gewünschten gleichbleibenden Abstand voneinander mit der gewünschten Geschwindigkeit v₂ abströmen.

Durch die Steuerung sowohl der vertikalen und horizontalen Bewegungsabläufe der Hebeeinrichtung als auch der Vorschubgeschwindigkeiten v₁ (Einlaufgeschwindigkeit) und v₂ (Auslaufgeschwindigkeit) sowohl in Abhängigkeit von der Ankunft der Leiterplattenvorderkante an der Position P1 als auch in Abhängigkeit von der Ankunft der Hinterkante der jeweils vorauseilenden Leiterplatte an der Position P₂ wird erfindungsgemäß eine Optimierung der Präzision erreicht, mit der der Leiterplattenstrom neu gebildet wird, weil die den definierten und konstanten Plattenabstand generierende Zeitsteuerung die Vorschubgeschwindigkeit der stromaufwärts gelegenen Bearbeitungsstation, die Vorschubgeschwindigkeit der stromabwärts gelegenen Bearbeitungsstation, den Abstand zwischen den Leiterplatten im Zustrom, die Taktzeit der Hebeeinrichtung und die Leiterplattenlänge jeweils gleichzeitig als Einflußgrößen berücksichtigt.

In vorteilhafter Weiterbildung des erfindungsgemäßen Verfahrens schließen die Bewegungsabläufe der Hebeeinrichtung eine definierte Wartezeit w₁ an der Position P₁ und eine definierte Wartezeit w₂ an der Position P₂ ein.

Neben der Pufferfunktion, die solche Wartezeiten haben und die der Überbrückung größerer und vor allem unregelmäßiger Abstände zwischen den einzelnen Platten des von der stromaufwärts gelegenen Bearbeitungsstation kommenden Plattenzustroms dienen, können diese Wartezeiten w₁ und w₂ vorteilhaft als Indikatoren zur Steuerung des Taktes und der Vorschubgeschwindigkeit der stromaufwärts gelegenen Bearbeitungsstation verwendet werden.

Dies wiederum dient der Einstellung und Aufrechterhaltung eines Gleichgewichts zwischen der Zahl der in die Station pro Zeiteinheit eintretenden Leiterplatten und der Zahl der aus der Station pro Zeiteinheit heraustransportierten Platten. Da die stromabwärts vorzugsweise folgende Galvanozelle mit konstanter Vorschubgeschwindigkeit und gleichbleibenden Abständen zwischen den Leiterplatten arbeitet, die vom Hersteller vorgegeben sind und aus physikalisch-chemischen Gründen entweder überhaupt nicht oder nur minimal verändert werden können, kann die Prozeßsteuerung zusätzlich nur auf die Variablen der stromaufwärts gelegenen Bearbeitungsstation Einfluß nehmen. Wenn sowohl die Wartezeit w₁ als auch die Wartezeit w₂ der Sollzeit entsprechen, sind Taktzeit und Vorschubgeschwindigkeit der stromaufwärts gelegenen Station korrekt. Ist dagegen w₁ größer und w₂ kleiner als die Sollzeit, sind Taktzeit und Vorschubgeschwindigkeit der stromaufwärts gelegenen Station zu langsam. Umgekehrt sind Taktzeit und Vorschubgeschwindigkeit der stromaufwärts gelegenen Station zu schnell, wenn w₁ kleiner und w₂ größer als die Sollzeit ist.

Vorzugsweise werden die Bewegungsabläufe der Hebeeinrichtung und die Vorschubgeschwindigkeiten v₁ und v₂ so gesteuert, daß zwischen den mit der Geschwindigkeit v₂ abströmenden Leiterplatten ein konstanter Abstand erzeugt wird, der im Bereich zwischen 5 und 10 mm liegt. Dieser Bereich ist für die sich in der Regel stromabwärts anschließenden Elektroplater optimal.

Vorteilhaft werden die Leiterplatten in Transportrichtung T kantenparallel ausgerichtet, und zwar in der Zeit, während sie mittels der Hebeeinrichtung bewegt werden oder, allgemeiner ausgedrückt, während sie sich im Einflußbereich der Hebeeinrichtung befinden. Die kantenparallele Ausrichtung bewirkt, daß alle Platten des neu generierten Leiterplattenstromes derart hintereinander angeordnet sind, daß mindestens eine ihrer Längskanten auf einer einzigen Geraden liegen.

Gleichzeitig kann die kantenparallele Ausrichtung aber auch so erfolgen, daß alle Platten des neu generierten Stromes bezüglich ihrer Längsachse zentriert sind.

Vorzugsweise wird erfindungsgemäß eine Hebeeinrichtung verwendet, deren Auflageflächen für die Leiterplatten vorübergehend in eine gegenüber der Horizontalen geneigte Lage verbracht werden. Besonders bevorzugt wird eine Hebeeinrichtung verwendet, deren Auflageflächen für die Leiterplatten so ausgebildet sind, daß die Leiterplatten in der geneigten Lage, vorzugsweise quer zur Transportrichtung T, leicht gegen eine oder mehrere Anschlagflächen rollen oder gleiten, wodurch sie sich automatisch kantenparallel ausrichten und entsprechend der Positionierung der Anschlagflächen gegebenenfalls zentrieren.

Die Leiterplatten werden an der Position P₁ vorzugsweise durch einen Anschlag angehalten, und die Ankunft und das Verweilen der Leiterplattenvorderkante am Anschlag, das der Wartezeit w₁ entspricht, werden von einem Sensor S₁ erfaßt, der die dabei erzeugten Steuersignale einer zentralen Prozeßsteuereinheit zuführt.

Um eine möglichst schonende Behandlung der Leiterplatten zu erreichen, werden diese vorzugsweise unmittelbar vor dem Auflaufen gegen den Anschlag abgebremst bzw. verzögert.

Schließlich werden der Zeitpunkt des Absenkens der Leiterplatten auf die Transportebene an der Position P₂ und damit auch die Dauer der Wartezeit w₂ durch die von einem Sensor S₂ erzeugten und der zentralen Prozeßsteuereinheit zugeführten Steuersignale bestimmt, wobei der Sensor S₂ die Ankunft der Hinterkante der jeweils vorauseilenden Leiterplatte erfaßt.

Stromaufwärts des Sensors S₁ und der Hebeeinrichtung kann bei einer anderen Ausführungsform der Erfindung ein dritter Sensor vorgesehen werden, der die Leiterplattenlänge und den Abstand zweier aufeinanderfolgenden Leiterplatten im Zustrom der Leiterplatten ermittelt und die dabei erzeugten Steuersignale ebenfalls an die zentrale Steuereinheit weiterleitet. Ein solcher dritter Sensor ist zwar nicht zwingend erforderlich, kann aber die Steuerung des Verfahrens und der Vorrichtung erleichtern.

Vorzugsweise wird die Hebeeinrichtung pneumatisch oder motorisch angetrieben.

Gegenstand der Erfindung ist ferner eine Vorrichtung zur Erzeugung eines definierten Stroms von in einer Transportebene horizontal geführten Leiterplatten, insbesondere zur Durchführung des erfindungsgemäßen Verfahrens, mit einem Gehäuse, das an einander gegenüberliegenden Wänden Öffnungen für den Durchlauf von Leiterplatten aufweist, die von einer stromaufwärts gelegenen Bearbeitungsstation oder -linie zu einer stromabwärts gelegenen Bearbeitungsstation oder -linie geführt werden, mit die Transportebene definierenden motorisch antreibbaren, im Abstand voneinander angeordneten Fördermitteln und einer horizontal verfahrbaren Hebeeinrichtung für die Leiterplatten sowie mit einer zentralen Prozeßsteuereinheit, wobei die Hebeeinrichtung als Auflageflächen für die Leiterplatten mehrere miteinander verbundene Greifarme aufweist, die vertikal durch die Transportebene hindurch verschiebbar und gemeinsam aus der Horizontalen verschwenkbar ausgebildet sind.

Damit wird erreicht, daß auf Saugheber und die dafür erforderliche Vakuumquelle verzichtet werden kann und die Vorrichtung gegenüber dem Stand der Technik insgesamt einfacher und mit geringerem Platzbedarf hergestellt werden kann. Ein besonderer Vorteil besteht darin, daß die zahlreichen Bohrlöcher in den Leiterplatten und unterschiedliche Leiterplattenformate die Generierung des neuen Leiterplattenstroms in keiner Weise negativ beeinflussen können, weil die Präzision des Plattentransportes nicht mehr von der Aufrechterhaltung eines bestimmten Unterdrucks in der Hebeeinrichtung abhängt.

Ein weiter wichtiger Vorteil der erfindungsgemäßen Vorrichtung besteht darin, daß die als Auflageflächen dienenden Greifarme gemeinsam aus der Horizontalen verschwenkbar sind, wodurch die Ausrichtung und gegebenenfalls Zentrierung der Leiterplatten gleichzeitig mit der Generierung des neuen Leiterplattenstroms erfolgen kann, also nicht mehr davor oder danach durchgeführt werden muß, was zu einer erheblichen Beschleunigung und Vereinfachung des mit der Vorrichtung durchgeführten Verfahrens führt.

Vorzugsweise weisen die Greifarme an ihren freien Enden je einen Anschlag auf, und sämtliche Anschläge bilden gemeinsam ein Mittel zum kantenparallelen Ausrichten der Leiterplatten in Transportrichtung T, ein Mittel, das wie ein Richtlineal wirkt, gegen das die Kanten der einzelnen Platten automatisch angelegt werden.

Vorzugsweise bilden die Anschläge gemeinsam ein Mittel zum Zentrieren der Leiterplatten in bezug auf ihre Längsachse oder in bezug auf eine nachfolgende Bearbeitungsstation oder -linie. Hierzu muß die Länge der Greifarme bzw. die Position der Anschläge entsprechend der gewünschten Symmetrie gewählt werden. In besonders vorteilhafter Ausgestaltung dieser Ausführungsform der Erfindung sind die Anschläge in Längsrichtung der Greifarme verstellbar ausgebildet.

Schließlich können die Greifarme Gleitmittel, vorzugsweise Rollen, aufweisen, über die die Leiterplatten mit möglichst geringem Reibungswiderstand und somit besonders schonend und beschädigungsfrei gegen die Anschläge gleiten oder rollen können, solange die Greifarme in eine aus der Horizontalen geneigte Lage verschwenkt sind.

Gemäß einer anderen vorteilhaften Ausführungsform der erfindungsgemäßen Vorrichtung sind die Greifarme gelenkig mit einer mechanischen Kurvensteuerung derart verbunden, daß sich die Auflageflächen für die Leiterplatten beim Anheben der Greifarme automatisch aus der Horizontalen heraus neigen und beim Absenken automatisch wieder in die Horizontale zurückkehren. Dabei weist die Hebeeinrichtung vorzugsweise ein Gehäuse auf, in das die Kurve der Kurvensteuerung integriert ist.

Die Hebeeinrichtung weist für ihre Horizontal- und Vertikalbewegung pneumatische oder motorische Antriebe auf, vorzugsweise über entsprechende Ventile ansteuerbare Pneumatikzylinder.

Eine weitere vorteilhafte Ausgestaltung der erfindungsgemäßen Vorrichtung besteht darin, daß sie einen ersten Sensor S₁ an einer durch einen Anschlag für die Leiterplatten definierten Position P₁ aufweist, der die Ankunft und das Verweilen der Leiterplattenvorderkante am Anschlag erfaßt und die dabei erzeugten Steuersignale der zentralen Prozeßsteuereinheit zuführt, und daß sie an einer stromabwärts von der Position P₁ gelegenen Position P₂ einen zweiten Sensor S₂ aufweist, der die Ankunft der Hinterkante der jeweils vorauseilenden Leiterplatte erfaßt und die dabei erzeugten Steuersignale der zentralen Prozeßsteuereinheit zuführt.

Ferner ist es von Vorteil, wenn die motorisch antreibbaren Fördermittel in zwei getrennt antreibbare Gruppen unterteilt sind, wobei die stromaufwärts des Anschlages für die Leiterplatten gelegenen Fördermittel die eine Gruppe und die stromabwärts des Anschlages für die Leiterplatten gelegenen Fördermittel die zweite Gruppe bilden, der Anschlag also die Grenze zwischen den beiden Gruppen darstellt. Die Fördermittel sind vorzugsweise Transportwalzen oder Transportrollen, es sind aber auch schmale, im Abstand voneinander angeordnete endlos umlaufende Transportbänder einsetzbar.

Die erfindungsgemäße Vorrichtung eignet sich besonders als Aufschließ- und Zentrierstation, die in einer im Horizontal-Durchlaufverfahren arbeitenden Leiterplatten-Herstellungslinie unmittelbar vor der Station oder Linie angeordnet wird, in der eine galvanische Metallabscheidung stattfindet und die gewöhnlich "Elektroplater" genannt wird.

Die Erfindung wird nachfolgend anhand der Zeichnung näher erläutert. Darin ist
Fig. 1 eine schematische Seitenansicht eines Ausführungsbeispiels für die erfindungsgemäße Vorrichtung, dargestellt in Phase I des Ablaufs des erfindungsgemäßen Verfahrens (Leiterplatte am Anschlag in Position P₁);
Fig. 2 eine schematische Vorderansicht der Vorrichtung von Fig. 1 im Zustand der Phase I;
Fig. 3 die Vorrichtung von Fig. 1 in schematischer Seitenansicht im Zustand der Phase IV (Leiterplatte in Position P₁ angehoben und aus der Horizontalen geneigt);
Fig. 4 die Vorderansicht der Vorrichtung von Fig. 3 in den Phasen II - IV (Anheben, Verschwenken, Abrollen der Leiterplatte);
Fig. 5 die Vorrichtung von Fig. 1 in schematischer Seitenansicht in Phase V (nach dem horizontalen Verschieben der Hebeeinrichtung);
Fig. 6 eine schematische Vorderansicht der Vorrichtung von Fig. 5 in Phase V;
Fig. 7 die Vorrichtung von Fig. 1 in schematischer Seitenansicht in Phase VI (nach dem Absenken der Hebeeinrichtung und Ablegen der Leiterplatte an Position P₂);
Fig. 8 eine Vorderansicht der Vorrichtung von Fig. 7 in Phase VI und VII (Absenken und Zurückschwenken in die Horizontale);
Fig. 9 eine schematische Seitenansicht der Vorrichtung von Fig. 1 in Phase VIII (Hebeeinrichtung wieder in Position P₁);
Fig. 10 eine Vorderansicht der Vorrichtung von Fig. 9 in Phase VIII;
Fig. 11 ein schematisches Schaltungsbild der zentralen Prozeßsteuereinheit.

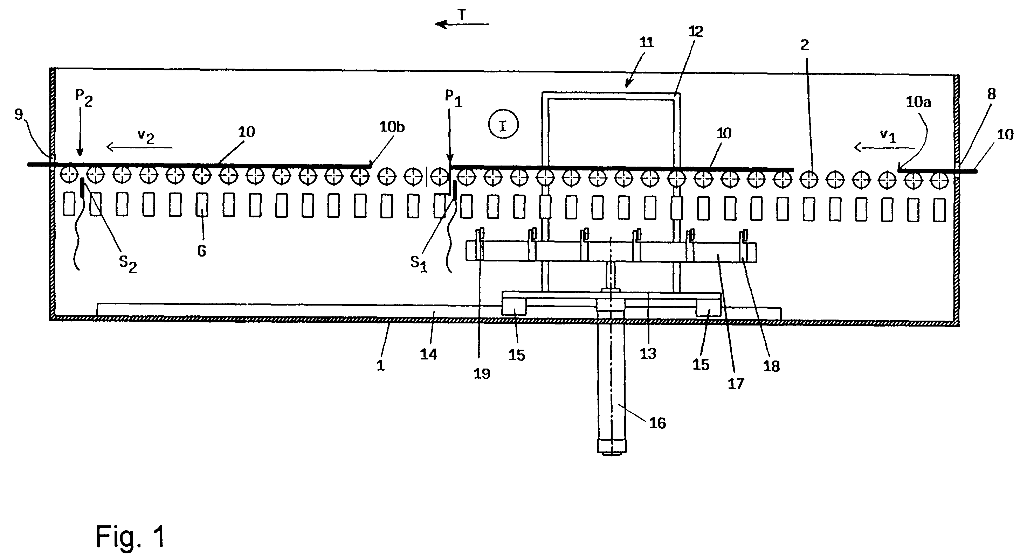

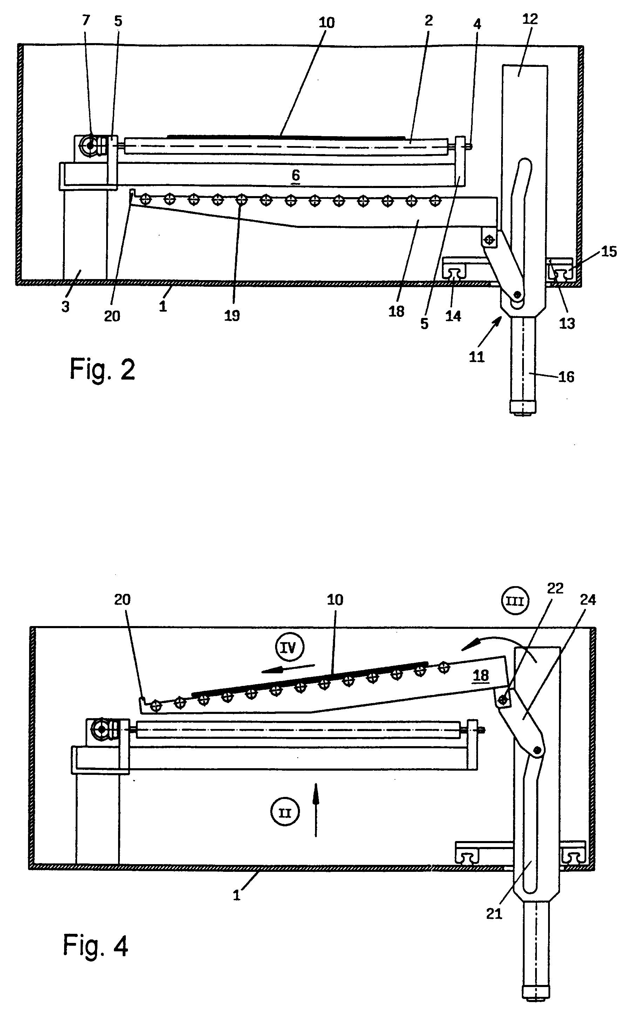

Das Gehäuse 1 der erfindungsgemäßen Vorrichtung (Figuren 1, 2) ruht auf einem nicht dargestellten Aluminiumgestell. Im Inneren des Gehäuses 1 sind Transportwalzen 2 angeordnet, die eine horizontale Transportebene für Leiterplatten 10 definieren, welche von einer stromaufwärts gelegenen Bearbeitungsstation mit konstanter Vorschubgeschwindigkeit v₁, durch die schlitzartige Öffnung 8 in das Gehäuse 1 in Form eines kontinuierlichen Leiterplattenstroms zugeführt und durch die Öffnung 9 in der gegenüberliegenden Wand des Gehäuses 1 mit konstanter Vorschubgeschwindigkeit v₂ zu einer stromabwärts gelegenen Bearbeitungsstation transportiert werden.

Die Transportwalzen 2 sind mit ihren Achsen 4 in Lagerleisten 5 gelagert, welche über Querträger 6 an einem Gerüst 3 abgestützt sind. Die Transportwalzen 2 sind in zwei Gruppen eingeteilt, die über zwei Hauptantriebswellen 7 getrennt voneinander mit einer veränderlich einstellbaren konstanten Geschwindigkeit angetrieben werden können.

Innerhalb des Gehäuses 1 ist ferner eine Hebeeinrichtung 11 auf einem Schlitten 13 montiert, der mit seinen Führungen 15 auf Schienen 14 mittels eines (nicht dargestellten) Pneumatikzylinders horizontal verfahrbar ist.

Die Hebeeinrichtung 11 besitzt ferner mehrere Greifarme 18, die über eine Traverse 17 miteinander verbunden sind. Die Traverse 17 wiederum ist über ein Drehgelenk 22 mit dem Schwenkarm 24 verbunden, der über eine mechanische Kurvensteuerung, angetrieben vom Pneumatikzylinder 16, in vertikaler Richtung angehoben und abgesenkt und gleichzeitig verschwenkt werden kann, wobei die Kurve 21 der Kurvensteuerung in das Gehäuse 12 der Hebeeinrichtung 11 integriert ist.

Die Greifarme 18 tragen jeweils mehrere Rollen 19, über die die Leiterplatten 10 leicht abrollen oder gleiten können, wenn die Greifarme 18 aus der Horizontalen in eine geneigte Lage verschwenkt werden. An den freien Enden der Greifarme 18 befindet sich jeweils ein Anschlag 20.

An der Position P₁ befindet sich ein Anschlag 25 für die Leiterplatten 10 und ein Sensor S₁, der die Ankunft der Leiterplattenvorderkante 10a und deren Verweilen am Anschlag 25 erfaßt und die dabei erzeugten Steuersignale der zentralen Prozeßsteuereinheit (nicht dargestellt) zuführt.

An der stromabwärts von der Position P₁ gelegenen Position P₂ befindet sich ein weiterer Sensor S₂, der die Ankunft der Hinterkante 10b der jeweils vorauseilenden Leiterplatte 10' erfaßt und die dabei erzeugten Steuersignale der zentralen Prozeßsteuereinheit zuführt.

Zur Durchführung des erfindungsgemäßen Verfahrens arbeitet die erfindungsgemäße Vorrichtung wie folgt:

### Phase I:

Die Hebeeinrichtung 11 wartet in ihrer Ausgangsposition (Wartezeit w₁) auf ein Signal der zentralen Prozeßsteuereinheit, das durch ein Signal des Sensors S₁ ausgelöst wird. Die mit der Vorschubgeschwindigkeit v₁ durch die Gehäuseöffnung 8 in die Vorrichtung einlaufende Leiterplatte 10 wird gegen den Anschlag 25 gefahren. Der Sensor S₁ erkennt, daß die Leiterplatte mit ihrer Vorderkante 10a am Anschlag 25 anliegt.

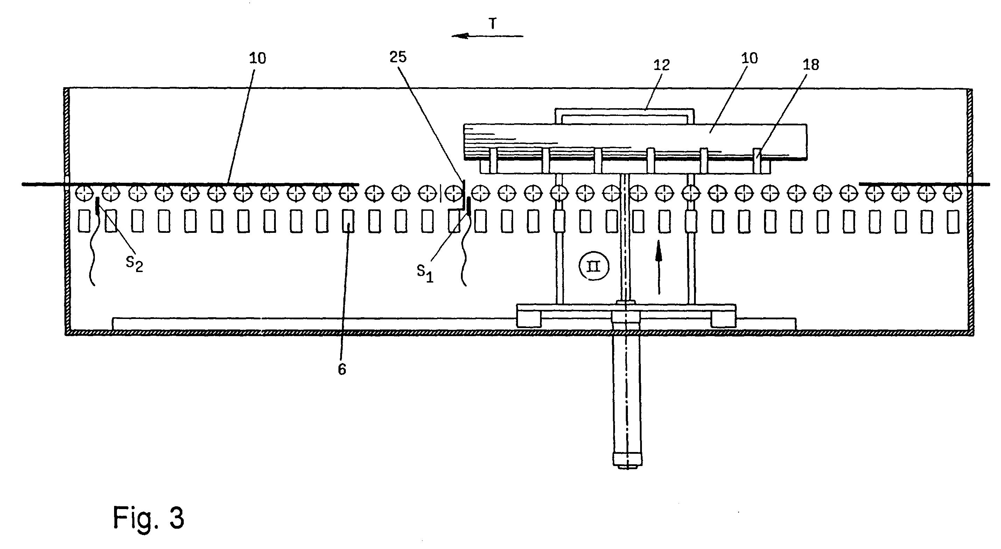

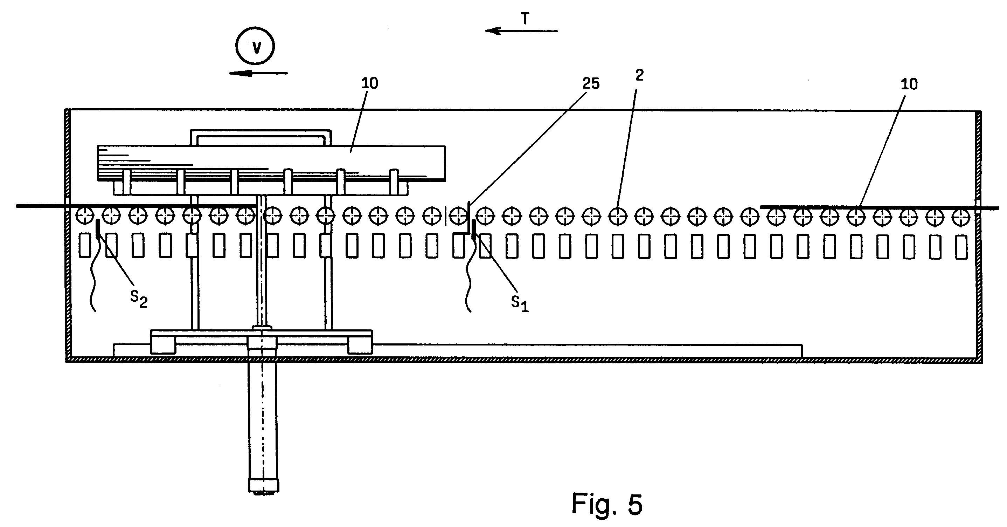

### Phase II (Figuren 3 und 4):

Durch Betätigung des Pneumatikzylinders 16 fahren die Greifarme 18 nach oben, durchkreuzen die Transportebene und heben die Leiterplatte 10 in eine oberhalb der Transportebene liegende horizontale Ebene an.

### Phase III:

Infolge der Kurvensteuerung neigen sich während der weiteren Hubbewegung die Greifarme 18 um das Drehgelenk 22 aus der Horizontalen in eine oberhalb der Transportebene liegende geneigte Ebene (Figur 4).

### Phase IV:

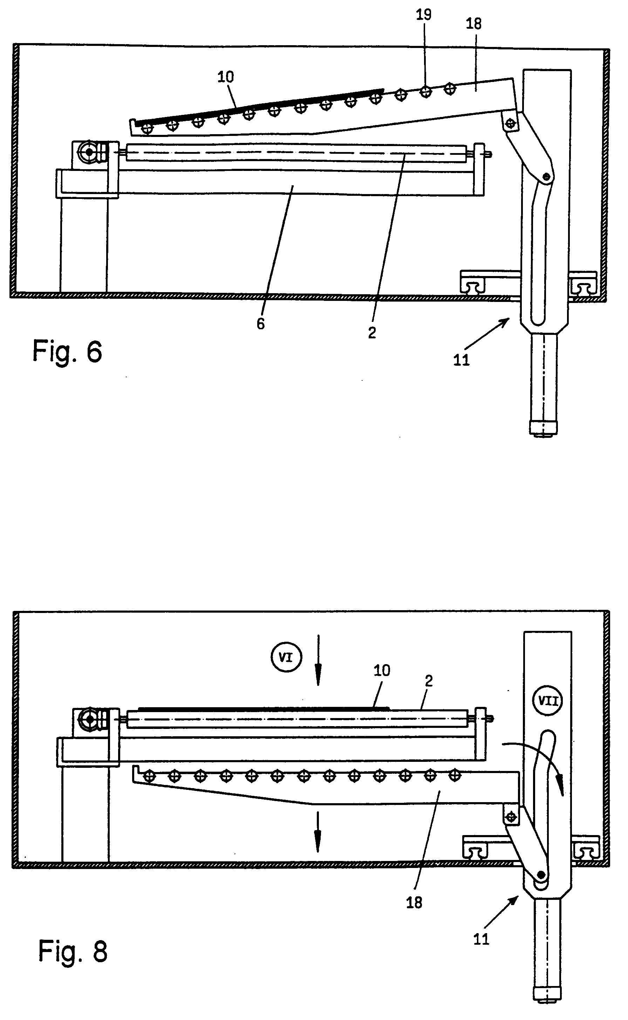

Infolge der Neigung der Greifarme 18 rollt die Leiterplatte 10 auf den Rollen 19 quer zur Transportrichtung T gegen die Anschläge 20, wodurch die Leiterplatte 10 in Transportrichtung T kantenparallel ausgerichtet wird (Figur 6).

### Phase V:

Die Hebeeinrichtung 11 wird auf den Schienen 14 horizontal in Durchlaufrichtung verfahren (Figur 5). Dabei überholt die in der Hebeeinrichtung 11 befindliche Leiterplatte 10 die im Leiterplattenstrom vorauseilende Leiterplatte 10', die gerade durch die Gehäuseöffnung 9 mit konstanter Vorschubgeschwindigkeit v₂ aus der Vorrichtung heraustransportiert wird. In ihrer Endposition angekommen, wartet die Hebeeinrichtung 11 auf ein Signal der zentralen Steuereinheit (Wartezeit w₂), das wiederum durch ein Signal des in Position P₂ befindlichen Sensors S₂ ausgelöst wird.

### Phase VI:

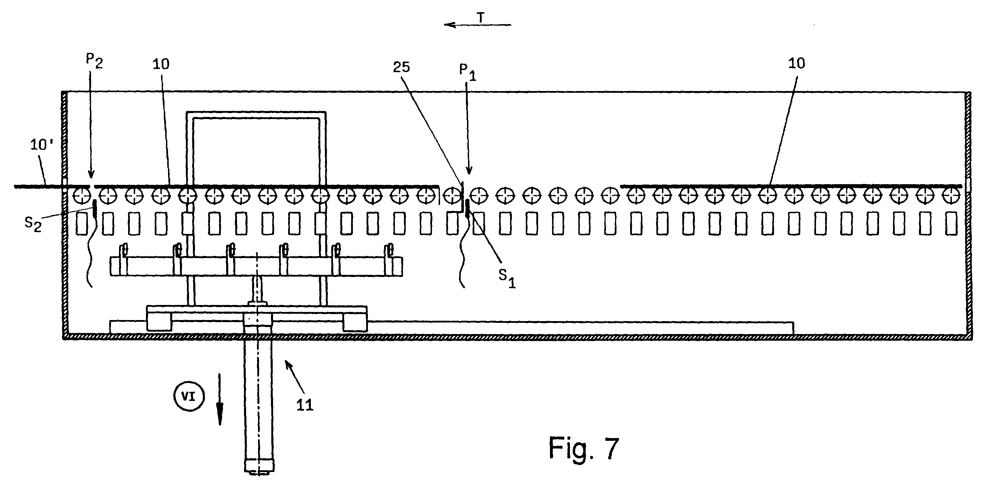

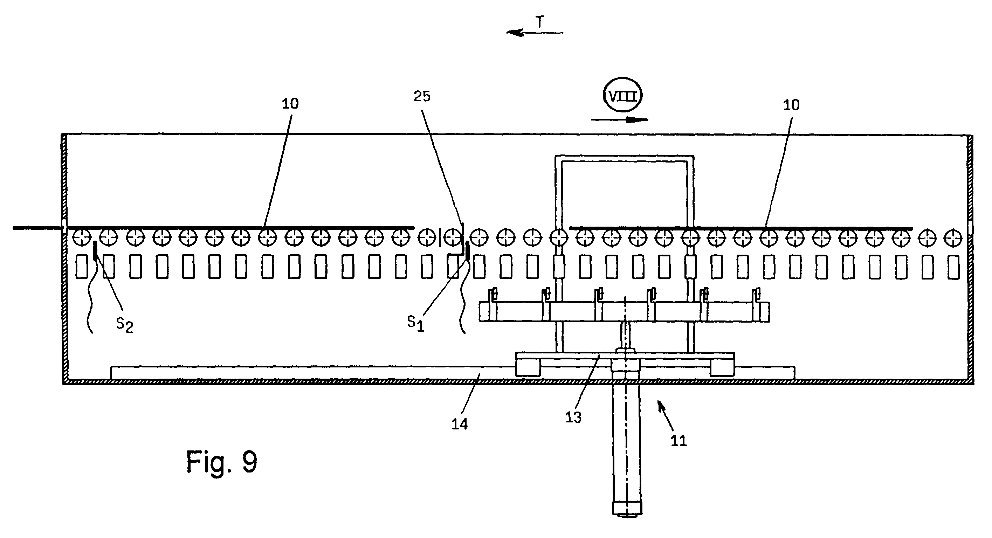

Der Sensor S₂ (Figur 7) erkennt die Hinterkante 10b der vorauseilenden Leiterplatte 10' und führt das dabei erzeugte Steuersignal der zentralen Prozeßsteuereinheit zu. Dadurch wird der Pneumatikzylinder 16 betätigt, die Greifarme 18 werden abgesenkt. Infolge der Kurvensteuerung (Figur 8) werden die Greifarme in die Horizontale zurückverschwenkt.

### Phase VII:

In horizontaler Lage wird die Leiterplatte 10 bei weiterem Absenken der Greifarme 18 auf die Transportwalzen 2 und damit auf die Transportebene abgesenkt, und dabei wird ein definierter Abstand zwischen der vorauseilenden Leiterplatte 10' und der Leiterplatte 10 erzeugt, der infolge der zentralen Zeitsteuerung konstant bleibt.

### Phase VIII:

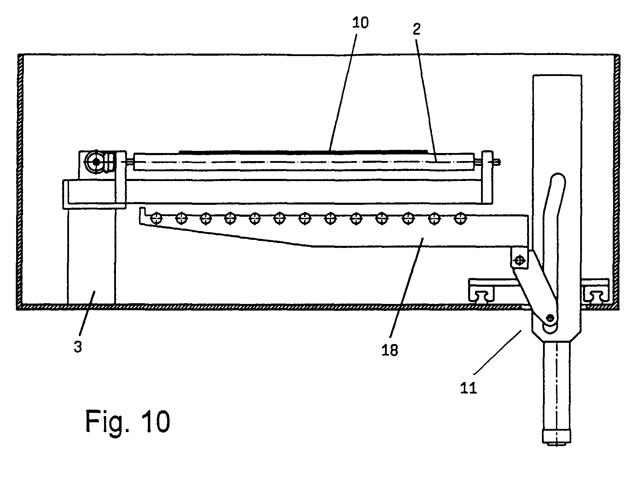

Die Hebeeinrichtung 11 wird durch Horizontalverschiebung des Schlittens 13 auf den Schienen 14 entgegen der Transportrichtung T wieder in ihre Ausgangsposition zurückgefahren und wartet erneut (Wartezeit w₁) auf ein vom Sensor S₁ beim Auflaufen der nächsten Leiterplatte 10 gegen den Anschlag 25 ausgelöstes Signal der zentralen Prozeßsteuereinheit (Figur 9, 10), worauf sich der gesamte Bewegungsablauf wiederholt.

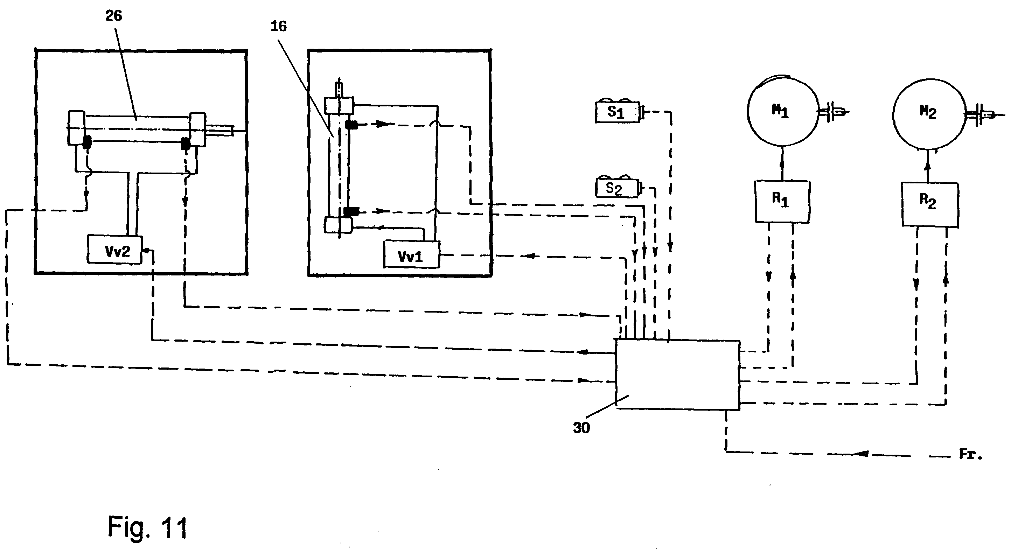

In Figur 11 ist schematisch der Signalfluß von und zur zentralen Prozeßsteuereinheit 30 dargestellt, die mit den Sensoren S₁ und S₂, mit den Ventilen Vv1, Vv2 zur Ansteuerung der Pneumatikzylinder 16, 26 für die vertikale und horizontale Bewegung der Hebeeinrichtung 11 sowie mit deren Endschaltern und mit den Stromrichtern R₁, R₂ der Motore M₁ und M₂ für die Hauptantriebswellen 7 der beiden Gruppen von Transportwalzen 2 verbunden ist. "Fr." steht für das Freigabesignal.

## Patentansprüche

1. Verfahren zur Erzeugung eines definierten Stroms von in einer Transportebene horizontal geführten Leiterplatten, bei dem die von einer stromaufwärts gelegenen Bearbeitungsstation kommenden, mit einer veränderlich einstellbaren, konstanten Vorschubgeschwindigkeit v₁ zugeführten Leiterplatten einzeln nacheinander an einer vorbestimmten Position P₁ angehalten, mittels einer horizontal verfahrbaren Hebeeinrichtung angehoben, oberhalb der Transportebene in Transportrichtung T beschleunigt und taktweise an einer vorbestimmten Position P₂ wieder auf die Transportebene abgesenkt werden, von wo sie mit einer veränderlich einstellbaren, konstanten Vorschubgeschwindigkeit v₂ einer stromabwärts gelegenen Bearbeitungsstation zugeführt werden, **dadurch gekennzeichnet**, daß die Bewegungsabläufe der Hebeeinrichtung und die Vorschubgeschwindigkeiten v₁ und v₂ in Abhängigkeit von der Ankunft der Leiterplattenvorderkante an der Position P₁ und der Ankunft der Hinterkante der jeweils vorauseilenden Leiterplatte an der Position P₂ so gesteuert werden, daß die Leiterplatten in einem gewünschten gleichbleibenden Abstand voneinander mit der gewünschten Geschwindigkeit v₂ abströmen.

2. Verfahren nach Anspruch 1, **dadurch gekennzeichnet**, daß die Bewegungsabläufe der Hebeeinrichtung eine definierte Wartezeit w₁ an der Position P₁ und eine definierte Wartezeit w₂ an der Position P₂ einschließen.

3. Verfahren nach Anspruch 2, **dadurch gekennzeichnet**, daß die Wartezeiten w₁ und w₂ als Indikatoren zur Steuerung des Taktes und der Vorschubgeschwindigkeit der stromaufwärts gelegenen Bearbeitungsstation verwendet werden.

4. Verfahren nach einem der Ansprüche 1 bis 3, **dadurch gekennzeichnet**, daß die Bewegungsabläufe der Hebeeinrichtung und die Vorschubgeschwindigkeiten v₁ und v₂ so gesteuert werden, daß zwischen den mit der Geschwindigkeit v₂ abströmenden Leiterplatten ein gleichbleibender Abstand von zwischen 5 und 10 mm erzeugt wird.

5. Verfahren nach einem der Ansprüche 1 bis 4, **dadurch gekennzeichnet**, daß die Leiterplatten in Transportrichtung T kantenparallel ausgerichtet werden, während sie mittels der Hebeeinrichtung bewegt werden.

6. Verfahren nach einem der Ansprüche 1 bis 5, **dadurch gekennzeichnet**, daß eine Hebeeinrichtung verwendet wird, deren Auflageflächen für die Leiterplatten vorübergehend in eine gegenüber der Horizontalen geneigte Lage verbracht werden.

7. Verfahren nach Anspruch 6, **dadurch gekennzeichnet**, daß eine Hebeeinrichtung verwendet wird, deren Auflageflächen für die Leiterplatten so ausgebildet sind, daß die Leiterplatten in der geneigten Lage, vorzugsweise quer zur Transportrichtung T, leicht gegen eine oder mehrere Anschlagflächen rollen oder gleiten.

8. Verfahren nach einem der Ansprüche 2 bis 7, **dadurch gekennzeichnet**, daß die Leiterplatten an der Position P₁ durch einen Anschlag angehalten werden und daß die Ankunft und das Verweilen (Wartezeit w₁) der Leiterplattenvorderkante am Anschlag von einem Sensor S₁ erfaßt wird, der die dabei erzeugten Steuersignale einer zentralen Prozeßsteuereinheit zuführt.

9. Verfahren nach Anspruch 8, **dadurch gekennzeichnet**, daß die Leiterplatten unmittelbar vor dem Auflaufen gegen den Anschlag abgebremst werden.

10. Verfahren nach einem der Ansprüche 2 bis 9, **dadurch gekennzeichnet**, daß der Zeitpunkt des Absenkens der Leiterplatten auf die Transportebene an der Position P₂ und damit die Dauer der Wartezeit w₂ durch die von einem Sensor S₂ erzeugten und der zentralen Prozeßsteuereinheit zugeführten Steuersignale bestimmt werden, wobei der Sensor S₂ die Ankunft der Hinterkante der jeweils vorauseilenden Leiterplatte erfaßt.

11. Verfahren nach einem der Ansprüche 1 bis 10, **dadurch gekennzeichnet**, daß die Hebeeinrichtung pneumatisch oder motorisch angetrieben wird.

12. Vorrichtung zur Erzeugung eines definierten Stroms von in einer Transportebene horizontal geführten Leiterplatten, insbesondere zur Durchführung des Verfahrens gemäß einem der Ansprüche 1 bis 11, mit einem Gehäuse (1), das an einander gegenüberliegenden Wänden Öffnungen (8, 9) für den Durchlauf von Leiterplatten (10) aufweist, die von einer stromaufwärts gelegenen Bearbeitungsstation oder -linie zu einer stromabwärts gelegenen Bearbeitungsstation oder -linie geführt werden, mit die Transportebene definierenden motorisch antreibbaren, im Abstand voneinander angeordneten Fördermitteln (2) und einer horizontal verfahrbaren Hebeeinrichtung (11) für die Leiterplatten (10) sowie mit einer zentralen Prozeßsteuereinheit (30), **dadurch gekennzeichnet**, daß die Hebeeinrichtung (11) als Auflageflächen für die Leiterplatten (10) mehrere miteinander verbundene Greifarme (18) aufweist, die vertikal durch die Transportebene hindurch verschiebbar und gemeinsam aus der Horizontalen verschwenkbar ausgebildet sind.

13. Vorrichtung nach Anspruch 12, **dadurch gekennzeichnet**, daß die Greifarme (18) an ihren freien Enden je einen Anschlag (20) aufweisen und daß die Anschläge (20) gemeinsam ein Mittel zum kantenparallelen Ausrichten der Leiterplatten (10) in Transportrichtung T bilden.

14. Vorrichtung nach Anspruch 13, **dadurch gekennzeichnet**, daß die Anschläge (20) gemeinsam ein Mittel zum Zentrieren der Leiterplatten (10) in bezug auf eine nachfolgende Bearbeitungsstation oder -linie bilden.

15. Vorrichtung nach Anspruch 12 oder 13, **dadurch gekennzeichnet**, daß die Anschläge (20) in Längsrichtung der Greifarme (18) verstellbar sind.

16. Vorrichtung nach einem der Ansprüche 12 bis 15, **dadurch gekennzeichnet**, daß die Greifarme (18) Gleitmittel, vorzugsweise Rollen (19), für die Leiterplatten aufweisen.

17. Vorrichtung nach einem der Ansprüche 12 bis 16, **dadurch gekennzeichnet**, daß die Greifarme (18) gelenkig mit einer mechanischen Kurvensteuerung derart verbunden sind, daß sich die Auflageflächen für die Leiterplatten (10) beim Anheben der Greifarme (18) automatisch aus der Horizontalen neigen und beim Absenken automatisch in die Horizontale zurückkehren.

18. Vorrichtung nach Anspruch 17, **dadurch gekennzeichnet**, daß die Hebeeinrichtung (11) ein Gehäuse (12) aufweist, in das die Kurve (21) der Kurvensteuerung integriert ist.

19. Vorrichtung nach einem der Ansprüche 12 bis 18, **dadurch gekennzeichnet**, daß die Hebeeinrichtung (11) für ihre Horizontal- und Vertikalbewegung pneumatische oder motorische Antriebe (16, 26) aufweist.

20. Vorrichtung nach einem der Ansprüche 12 bis 19, **dadurch gekennzeichnet**, daß sie einen ersten Sensor S₁ an einer durch einen Anschlag (25) für die Leiterplatten (10) definierten Position P₁ aufweist, der die Ankunft und das Verweilen der Leiterplattenvorderkante (10a) am Anschlag (25) erfaßt und die dabei erzeugten Steuersignale der zentralen Prozeßsteuereinheit (30) zuführt, und daß sie an einer stromabwärts von der Position P₁ gelegenen Position P₂ einen zweiten Sensor S₂ aufweist, der die Ankunft der Hinterkante (10b) der jeweils vorauseilenden Leiterplatte (10') erfaßt und die dabei erzeugten Steuersignale der zentralen Prozeßsteuereinheit (30) zuführt.

21. Vorrichtung nach einem der Ansprüche 12 bis 20, **dadurch gekennzeichnet**, daß die motorisch antreibbaren Fördermittel (2) in zwei getrennt antreibbare Gruppen unterteilt sind, wobei der Anschlag (25) die Grenze zwischen den beiden Gruppen bildet.

22. Vorrichtung nach einem der Ansprüche 12 bis 21, **dadurch gekennzeichnet**, daß die Fördermittel (2) Transportwalzen oder -rollen sind.

23. Verwendung der Vorrichtung gemäß einem der Ansprüche 12 bis 22 als Aufschließ- und Zentrierstation unmittelbar vor der Station oder Linie, in der eine galvanische Metallabscheidung auf den Leiterplatten durchgeführt wird (Eletroplater), in einer im Horizontal-Durchlaufverfahren arbeitenden Leiterplatten-Herstellungslinie.
